# EUROPÄISCHE PATENTANMELDUNG

(11) **EP 0 816 861 A2**
(43) Veröffentlichungstag der Anmeldung: **07.01.1998**
(21) Anmeldenummer: 97108109.6
(22) Anmeldetag: 15.05.1997
(51) Int. Cl.: G01R 33/028

(54) **Vorrichtung zum Messen magnetischer Feldstärken**

(30) Priorität: 25.06.1996 DE 19625403
(71) Anmelder: SIEMENS AKTIENGESELLSCHAFT, 80333 München (DE)
(72) Erfinder: Magori, Erhard, D-81539 München (DE); Hirold, Christopfer, D-81739 München (DE); Màgori, Valentin, D-81539 München (DE); Näher, Ulrich, D-80803 München (DE)

(57) **Zusammenfassung**

Vorrichtung, bei der die Stärke eines Magnetfeldes mit zumindest bereichsweise ortsunabhängiger Richtung, wie es z. B. von einem stromdurchflossenen elektrischen Leiter hervorgerufen wird, dadurch bestimmt wird, daß die Spannung gemessen wird, die in einer z. B. mittels kammartig geformter und miteinander verzahnter Elektroden (7, 8) durch elektrostatische Kräfte verformbaren Leiterschleife (2) als Folge der Änderung des diese Leiterschleife durchdringenden Magnetflusses induziert wird.

## Beschreibung

Die vorliegende Erfindung betrifft eine Vorrichtung zum Messen der Stärke von Magnetfeldern mit zumindest bereichsweise ortsunabhängiger Richtung.

Die zeitliche Änderung des magnetischen Flusses durch eine geschlossene Leiterschleife induziert in diesem Leiter eine elektrische Spannung. Der magnetische Fluß ist gegeben durch das Integral des B-Feldes über die von der Leiterschleife eingeschlossene Fläche. Bei zeitlich konstantem Magnetfeld ändert sich der magnetische Fluß nur infolge einer Änderung des Integrationsbereiches, d. h. der von der Leiterschleife eingeschlossenen Fläche. Bei einer bekannten Änderung der Form und Lage der Leiterschleife ist es daher möglich, bei zeitlich konstantem B-Feld die infolge der Änderung in der Leiterschleife induzierte Spannung zu berechnen. Umgekehrt läßt sich die mittlere Stärke des B-Feldes aus dieser Spannung bestimmen. Das B-Feld kann z. B. von einem elektrischen Strom hervorgerufen sein.

Aufgabe der vorliegenden Erfindung ist es, eine einfach herzustellende Vorrichtung zur Messung kleiner magnetischer Felder, die zumindest bereichsweise ortsunabhängige Richtung haben, anzugeben. Diese Meßvorrichtung soll insbesondere für vielfältigen praktischen Einsatz geeignet sein.

Diese Aufgabe wird mit der Vorrichtung mit den Merkmalen des Anspruches 1 gelöst. Weitere Ausgestaltungen dieser Vorrichtung sowie Anordnungen mit dieser Vorrichtung ergeben sich aus den abhängigen Ansprüchen.

Die erfindungsgemäße Vorrichtung verfügt über eine Leiterschleife, insbesondere einen ringförmigen oder rahmenförmigen und vorzugsweise fast vollständig geschlossenen elektrischen Leiter, die vorzugsweise in einer Ebene liegt ("ebene Leiterschleife"). Die Form oder Lage dieser Leiterschleife kann mittels einer dafür vorgesehenen Vorrichtung verändert werden. Auf diese Weise ist es möglich, eine von der Leiterschleife begrenzte und von den magnetischen Feldlinien durchsetzte Fläche so abzuändern oder mit der bewegten oder verformten Leiterschleife eine von magnetischen Feldlinien durchsetzte Fläche derart zu überstreichen, daß eine elektrische Spannung induziert wird, die an den Enden der Leiterschleife abgegriffen werden kann. Zum Messen eines Magnetfeldes mit konstanter ortsunabhängiger Richtung wird die Leiterschleife vorzugsweise in einer Ebene senkrecht zu den Feldlinien angeordnet und nur innerhalb dieser Ebene verformt. Bei einem homogenen Magnetfeld ist die Änderung des Magnetflusses proportional zur Änderung der von der Leiterschleife begrenzten Fläche. Bei nicht homogenem Magnetfeld muß die unterschiedliche Stärke des Magnetfeldes an verschiedenen Punkten der betrachteten Fläche berücksichtigt werden. Wenn die räumliche Änderung des Magnetfeldes wie z. B. bei dem von einem Strom in einem geradlinigen Leiter um diesen Leiter herum erzeugten Magnetfeld bekannt ist, kann die mittlere Stärke des Magnetfeldes in einem eng begrenzten Bereich im Abstand zu diesem Leiter aus der Änderung der Fläche der Leiterschleife durch Vergleich mit bereits gemessenen Bezugswerten bestimmt werden. In diesem Fall läßt sich aus der Messung der Stärke des Magnetfeldes die Stärke des in dem Leiter fließenden Stromes bestimmen.

Die Leiterschleife dieser Vorrichtung kann eine im wesentlichen elastische Drahtschleife oder ein metallischer Rahmen oder dergleichen sein. Erfindungsgemäß wird diese Vorrichtung als (insbesondere mikromechanisches) Halbleiterbauelement realisiert. Bei einer möglichen Ausführungsform ist die Leiterschleife z. B. in einer Schicht aus Polysilizium strukturiert. Die Leiterschleife kann auch in einer Body-Siliziumschicht (obere dünne, z. B. etwa 4µm dicke Siliziumschicht über einer isolierenden Schicht auf einer Siliziumscheibe) eines SOI-Substrates strukturiert sein. Die Leiterschleife kann auch in einer für Leiterbahnen einer elektronischen Schaltung vorgesehenen Metallisierungsebene ausgebildet sein. Als Leiterschleife kann alternativ eine Anordnung aus einer elektrisch leitenden Schicht, vorzugsweise aus (mindestens) zwei im Abstand zueinander angeordneten leitenden Schichten, die nur an einer Seite elektrisch leitend miteinander verbunden sind, fungieren. Eine dieser Schichten kann z. B. ein elektrisch leitend dotierter Schichtanteil eines Halbleitersubstrates sein.

Die Verformung der die Leiterschleife bildenden Struktur erfolgt vorzugsweise durch eine elektrostatische Einwirkung. Zu diesem Zweck ist eine Vorrichtung vorgesehen, die zwischen der Leiterschleife oder einen speziell ausgebildeten Teil der Leiterschleife und einer ortsfest angebrachten Elektrode eine elektrische Spannung anlegt, insbesondere eine Wechselspannung, z. B. im Bereich akustischer Frequenzen, wodurch bewirkt wird, daß die beweglichen (elastischen) Teile der Leiterschleife von den auftretenden elektrostatischen Kräften verformt werden und sich daher die von der Leiterschleife eingeschlossene Fläche ändert oder die Leiterschleife durch das zu messende Magnetfeld hindurch bewegt wird. Die in der Leiterschleife bei Vorhandensein eines Magnetfeldes induzierte elektrische Spannung wird an den Enden der Leiterschleife abgegriffen. Diese Spannungsänderung ist ein Maß für die Stärke des Magnetfeldes, das die von der Leiterschleife begrenzte oder überstrichene Fläche durchsetzt.

Es folgt eine Beschreibung der erfindungsgemäßen Vorrichtung anhand der Figuren 1 bis 5.
- Figur 1: zeigt eine bevorzugte Anordnung der erfindungsgemäßen Vorrichtung, die in dieser Form z. B. als Strommesser verwendet werden kann.
- Figuren 2 und 3: zeigen zwei spezielle Ausführungsbeispiele.
- Figur 4: zeigt das Ausführungsbeispiel der Figur 3 in einer Draufsicht.
- Figur 5: zeigt ein weiteres Ausführungsbeispiel.

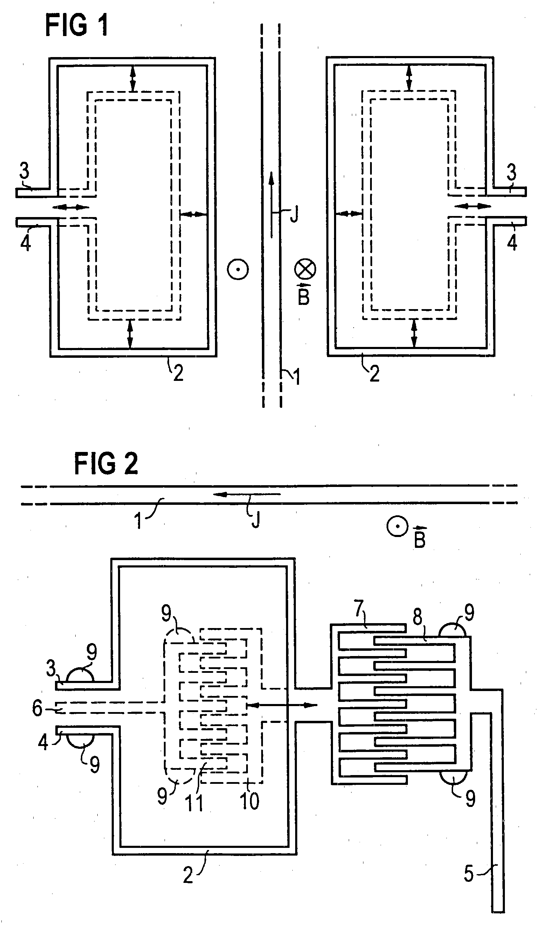

Figur 1 zeigt eine typische Anordnung, die z. B. zur indirekten Bestimmung der Stärke des in dem eingezeichneten geradlinigen Leiter 1 fließenden Stromes dienen kann. Es sind dort zwei Leiterschleifen 2 mit elektrischen Anschlüssen 3, 4 eingezeichnet. Das Magnetfeld steht senkrecht auf der Zeichenebene. Mit gestrichelten Konturen ist schematisch eine mögliche Änderung der von der Leiterschleife 2 umschlossenen Fläche dargestellt. Die Leiterschleife wird in Richtung der eingezeichneten Doppelpfeile verkleinert und vergrößert. Mit einer solchen beidseitigen Anordnung von verformbaren Leiterschleifen läßt sich der Einfluß eines zusätzlichen statischen Magnetfeldes eliminieren. Es wird dann nur das in diesem Beispiel von dem fließenden Strom erzeugte Magnetfeld gemessen. Bei einer Änderung der Stromstärke I ändert sich der Betrag der magnetischen Feldstärke B, was entsprechend von der Vorrichtung erfaßt wird. Diese Anordnung ist daher geeignet, die in dem Leiter 1 fließende Stromstärke zu bestimmen. Die erfindungsgemäße Vorrichtung kann daher als Strommesser oder Stromzähler, z. B. zur Erfassung des verbrauchten Stromes in Haushalten, eingesetzt werden.

Eine konkrete Ausgestaltung ist in Figur 2 als Beispiel dargestellt. Die Leiterschleife 2 ist in einem festen Abstand zum geradlinigen stromführenden Leiter 1 angeordnet. Es ist eine kammartige Struktur als Elektrode 7 an der Leiterschleife befestigt. Diese Elektrode ist mit einer ebenfalls kammartigen Elektrode 8 verzahnt, die ortsfest angebracht ist, d. h. die relativ zum Leiter 1 befestigt ist. Befestigende Träger oder Halter 9 sind als Beispiel an verschiedenen Stellen der fest installierten Teile eingezeichnet. Die Leiterschleife 2 verfügt über elektrische Anschlüsse 3, 4; ebenso verfügt die orstfeste Elektrode 8 über einen elektrischen Anschluß 5. Die elektrischen Anschlüsse können z. B. auf einer Unterlage befestigt werden, um zu verhindern, daß sie bei einer Veränderung der Form der Leiterschleife 2 ihre Position verändern oder einen Kurzschluß verursachen. Bei einer möglichen Ausführungsform dieser Vorrichtung ist die Leiterschleife 2 z. B. in einer Polysiliziumschicht strukturiert, und die elektrischen Anschlüsse 3, 4 sind auf der Unterlage, z. B. einem Halbleitersubstrat aus Silizium, fest verankert. Weitere Kalter 9 können z. B. durch Stützen aus Silizium oder Polysilizium gebildet sein. Die kammartig verzahnte Struktur der vorhandenen Elektroden 7, 8 dient in diesem Beispiel der Verformung der Leiterschleife 2 entsprechend dem eingezeichneten Doppelpfeil. Je nach der Befestigung der Leiterschleife 2 auf der Unterlage können verschiedene Arten von Verformungen der Leiterschleife 2 hervorgerufen werden. Die Verformung der Leiterschleife muß nur in der Weise erfolgen, daß die zeitliche Änderung der von der Leiterschleife umgrenzten Fläche feststellbar ist. Wenn die Leiterschleife in ausreichend großem Abstand von dem Leiter 1 angeordnet ist und die umgrenzte Fläche und damit die zeitliche Änderung der umgrenzten Fläche ausreichend klein sind, so daß das Magnetfeld im Innern der Leiterschleife als näherungsweise homogen angesehen werden kann, ist die zeitliche Änderung des magnetischen Flusses und damit die induzierte Spannung direkt proportional zu der zeitlichen Änderung des Inhalts der von der Leiterschleife umgrenzten Fläche. Falls das Magnetfeld nicht ausreichend homogen ist, muß bei der Verformung der Leiterschleife berücksichtigt werden, daß sich eine Änderung des magnetischen Flusses durch die Leiterschleife nicht nur aufgrund einer Änderung des Inhalts der umgrenzten Fläche ergibt.

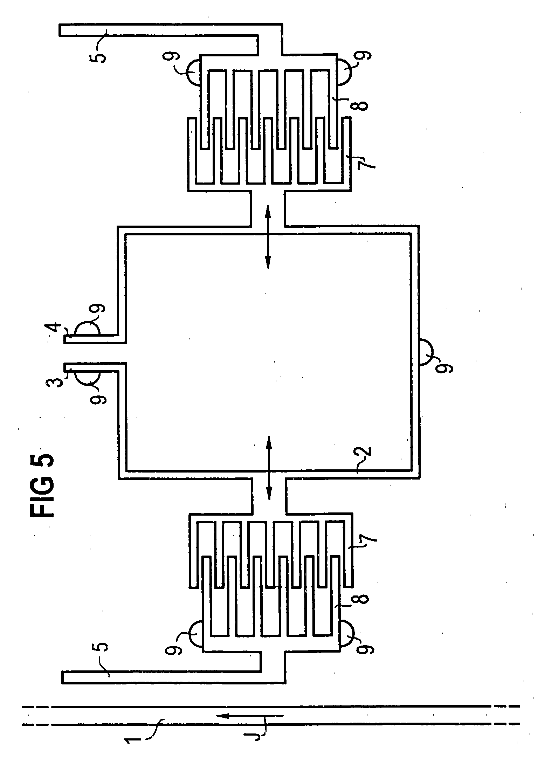

Bei einem einzelnen geradlinigen stromführenden Leiter ist der Betrag des von dem Strom hervorgerufenen Magnetfeldes umgekehrt proportional zum Abstand von dem Leiter. Wenn der Leiter 1 und die Leiterschleife 2 in derselben Ebene (Zeichenebene der Figur 2) angeordnet sind, so daß das zu messende Magnetfeld senkrecht auf der Ebene der Leiterschleife steht, ist es vorteilhaft, wenn die Verformung der Leiterschleife in der Weise erfolgt, daß die geradlinigen Anteile der Leiterschleife, die parallel zu dem Leiter 1 verlaufen, gegensinnig zueinander senkrecht zu ihrer Längsrichtung bewegt werden und die beiden anderen geradlinigen Anteile der in diesem Beispiel rechteckigen Leiterschleife im wesentlichen unverändert bleiben. Die Änderung des magnetischen Flusses durch die Leiterschleife ist in diesem Fall nämlich proportional zu der zeitlichen Änderung des Abstandes einer bewegten Seite der Leiterschleife von dem stromführenden Leiter 1. Eine derartige Verformung der Leiterschleife kann z. B. dadurch erreicht werden, daß statt der durch den Halter 9 gegebenen Befestigung der Leiterschleife 2 eine weitere kammartige Elektrode auf dieser Seite der Leiterschleife vorhanden ist, die mit einer ortsfest angeordneten kammartigen Gegenelektrode verzahnt ist, so daß bei Anlegen entsprechender Spannungen zwischen den jeweiligen Elektroden eine gegensinnige Verformung der Leiterschleife erfolgen kann. In diesem Fall ergibt sich eine Anordnung, die im Prinzip der in Figur 5 als Beispiel angegebenen entspricht. Es ist der Abstand zwischen dem Leiter 1 und der Leiterschleife 2 hierbei ggf. größer zu wählen als bei der in der nicht maßstabsgetreuen Darstellung der Figur 2 dargestellten Anordnung.

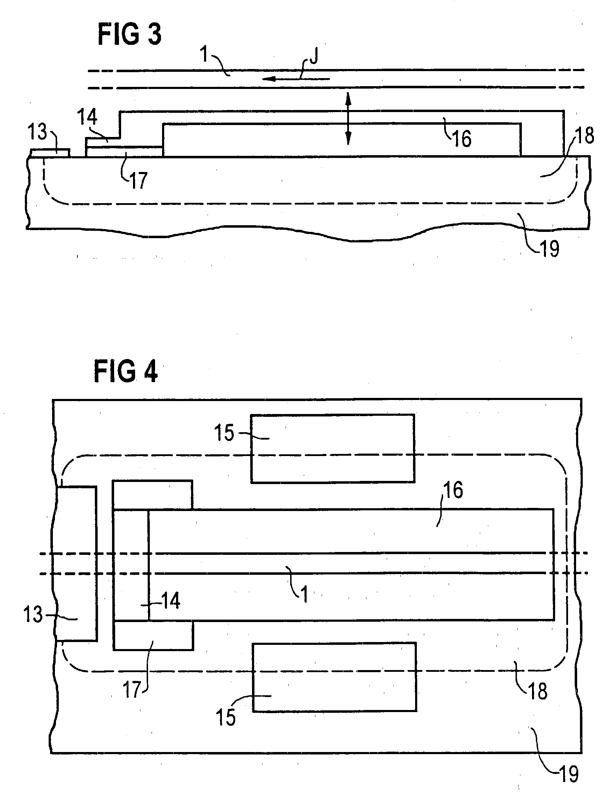

Bei dem Ausführungsbeispiel der Figur 3 befindet sich eine streifenförmige leitfähige Schicht 16 im Abstand über einem dotierten Bereich 18 in einem Halbleitersubstrat 19. Diese Schicht 16 ist an einer Schmalseite auf dem Substrat 19 befestigt und in elektrisch leitendem Kontakt mit diesem leitend dotierten Bereich 18. An der anderen Schmalseite befindet sich zwischen dem dotierten Bereich 18 und der Befestigung der streifenförmigen Schicht 16 eine Isolationsschicht 17. Bei der Ausführungsform der Figur 3 befindet sich auf dieser Seite der streifenförmigen Schicht 16 ein für einen elektrischen Anschluß vorgesehener Kontaktbereich 14 und auf dem dotierten Bereich ein z. B. metallischer Anschlußkontakt 13. Durch den dotierten Bereich 18 und die streifenförmige Schicht 16 ist daher zwischen den Anschlüssen 13, 14 eine Leiterschleife ausgebildet. Auf der von dem Substrat 19 abgewandten Seite der Schicht 16 kann z. B. entsprechend Figur 2 ein geradliniger stromführender Leiter 1 angeordnet sein, der das zu messende Magnetfeld hervorruft. Dieses Ausführungsbeispiel ist in Figur 4 in Draufsicht gezeichnet. Für die Verformung der Schicht 16 entsprechend dem in Figur 3 eingezeichneten Doppelpfeil wird eine Spannung zwischen dieser Schicht 16 und dem dotierten Bereich 18 angelegt, wofür bei dieser Ausführungsform die zusätzlichen Anschlußkontakte 15 auf dem dotierten Bereich 18 vorgesehen sind. Die die Verformung hervorrufende Spannung wird zwischen den Anschlüssen 14 und 15, die den Anschlüssen 4 und 5 der Ausführungsformen der Figur 2 entsprechen, angelegt. Die induzierte Spannung kann statt dessen an den Enden der Schicht 16 abgegriffen werden, die dann allein als Leiterschleife fungiert. Ein dotierter Bereich 18 in dem Halbleitersubstrat kann dann weggelassen werden oder nur für die elektrostatisch bewirkte Bewegung der Schicht 16 vorgesehen sein.

In Figur 2 ist eine zusätzliche kammartig verzahnte Elektrodenstruktur mit gestrichelten Konturen eingezeichnet. Die Elektrode 10 ist an der Leiterschleife 2 befestigt, während die kammartige Elektrode 11 z. B. mittels Haltern 9 ortsfest angebracht ist und über einen elektrischen Anschluß 6 verfügt. Eine derartige zusätzliche Elektrodenstruktur kann zur Kontrolle der Verformung der Leiterschleife verwendet werden. Mit dazu geeigneten schaltungstechnischen Mitteln können die Frequenz und die Amplitude von Bewegungen der Leiterschleife 2 gemessen und gesteuert werden.

Die erfindungsgemäße Vorrichtung ist insbesondere zum Einsatz als Stromzähler in Haushalten oder Gewerbebetrieben geeignet. Bei einer fest vorgegebenen Anordnung zwischen dem durchflossenen Leiter und der Leiterschleife sind im Prinzip beliebige Änderungen von Lage und Form der Leiterschleife im Zuge der Messung möglich, wenn die bei gegebener Verformung gemessene Spannungsänderung an den Enden der Leiterschleife mit Bezugswerten verglichen werden kann. Diese Bezugswerte können z. B. für eine bestimmte Anordnung ermittelt und abgespeichert werden. Eine feste Anordnung aus einem geradlinigen Leiter 1 und der erfindungsgemäßen Vorrichtung zur Bestimmung von magnetischen Feldstärken kann daher in einem Stromzähler zur Bestimmung des Stromverbrauches eingesetzt werden. Die Leiterschleife kann ebenso aus mehreren miteinander in elektrischem Kontakt stehenden, aber relativ zueinander beweglichen Teilen gebildet sein, so daß z. B. die Verformung der Leiterschleife entsprechend den Beispielen der Figur 1 realisierbar ist. Als Material für die Leiterschleife wird vorzugsweise nicht oder nur gering magnetisierbares (relative Permeabilitätskonstante etwa = 1) Material verwendet. Die Ausführung der erfindungsgemäßen Vorrichtung als mikromechanisches Bauelement z. B. in Silizium bietet einerseits den Vorteil einfacher Herstellbarkeit im Rahmen der für mikromechanische Bauelemente eingesetzten Herstellungsprozesse und andererseits die Möglichkeit, die für die Auswertung vorgesehene elektronische Schaltung in dasselbe Bauelement zu integrieren.

## Patentansprüche

1. Vorrichtung zum Bestimmen der Stärke von Magnetfeldern, bei der in einem Halbleiterbauelement eine bewegliche oder verformbare Leiterschleife (2) vorhanden ist,
bei der Enden (3, 4) dieser Leiterschleife mit einer elektronischen Schaltung zur Messung einer in dieser Leiterschleife induzierten elektrischen Spannung verbunden sind und
bei der eine Einrichtung vorhanden ist, mit der die Form oder Lage dieser Leiterschleife in einer vorgesehenen Weise geändert werden kann.

2. Vorrichtung nach Anspruch 1,
bei der die elektronische Schaltung mit dem Halbleiterbauelement integriert und dafür vorgesehen ist, aus einer gemessenen Änderung der elektrischen Spannung zwischen den Enden der Leiterschleife die Stärke des zu messenden Magnetfeldes oder eines das Magnetfeld erzeugenden elektrischen Stromes zu ermitteln.

3. Vorrichtung nach Anspruch 1 oder 2,
bei dem die Leiterschleife durch eine strukturierte Metallisierungsebene gebildet wird.

4. Vorrichtung nach Anspruch 1 oder 2,
bei dem die Leiterschleife durch eine strukturierte Siliziumschicht gebildet wird.

5. Vorrichtung nach einem der Ansprüche 1 bis 4,
bei der die Einrichtung zum Ändern der Leiterschleife eine an einem beweglichen Anteil der Leiterschleife vorhandene Elektrode (7; 16) und eine an dem Halbleiterbauelement fest angeordnete Elektrode (8; 18) umfaßt.

6. Vorrichtung nach Anspruch 5,
bei der die an der Leiterschleife vorhandene Elektrode (7) und die fest angeordnete Elektrode (8) je eine kammartige Struktur aufweisen,
bei der diese kammartigen Strukturen miteinander verzahnt sind, ohne in elektrisch leitender Verbindung zu stehen, und
bei der Mittel (4, 5) vorgesehen sind, mit denen zwischen diesen Elektroden (7, 8) eine elektrische Spannung angelegt werden kann.

7. Vorrichtung nach Anspruch 5,
bei der die fest angeordnete Elektrode durch einen dotierten Bereich (18) in einem Halbleitersubstrat (19) gebildet ist,
bei der die Leiterschleife eine streifenförmige, verformbare, elektrisch leitende Schicht (16) umfaßt,
bei der diese Schicht in einem Abstand zu diesem dotierten Bereich angeordnet ist und
bei der Mittel (13, 14, 15) für elektrischen Anschluß dieser Schicht und dieses Bereiches vorhanden sind.

8. Vorrichtung nach Anspruch 7,
bei der die streifenförmige Schicht an ihren beiden Schmalseiten auf dem Halbleitersubstrat derart befestigt ist, daß nur an einer Seite eine elektrisch leitende Verbindung zwischen dieser Schicht und diesem dotierten Bereich besteht.

9. Vorrichtung nach einem der Ansprüche 1 bis 8,
bei der Mittel vorgesehen sind, mit denen die Vorrichtung in einem vorgegebenen Abstand zu einem von der Leiterschleife elektrisch isolierten elektrischen Leiter (1) gehalten werden kann.

10. Anordnung mit zwei Vorrichtungen nach Anspruch 9 und mit einem geradlinigen elektrischen Leiter,
bei der dieser Leiter und die Leiterschleifen dieser Vorrichtungen in derselben Ebene angeordnet sind und der Leiter zwischen den Leiterschleifen angeordnet ist.
